# EUROPÄISCHE PATENTSCHRIFT

(11) **EP 0 853 567 B1**
(45) Veröffentlichungstag und Bekanntmachung des Hinweises auf die Patenterteilung: **12.04.2000**
(21) Anmeldenummer: 96934524.8
(22) Anmeldetag: 03.10.1996
(51) Int. Cl.: B60S 3/00, G01V 8/12

(54) **Optisches Erfassungssystem in einer Waschanlage für Fahrzeuge und Verfahren zu seinem Betrieb**
Optical Detection System in a Car-Wash Installation and Method of Operating the same
Système de détection optique pour station de lavage de véhicules et procédé de son opération

(30) Priorität: 07.10.1995 DE 19537428
(43) Veröffentlichungstag der Anmeldung: 22.07.1998
(73) Patentinhaber: California Kleindienst Holding GmbH, 86153 Augsburg (DE)
(72) Erfinder: AUER, Robert, D-86391 Leitershofen (DE); WINDEL, Günter, D-63825 Schöllkrippen (DE)
(74) Vertreter: Ernicke, Hans-Dieter, Dipl.-Ing.
(86) Internationale Anmeldenummer: EP9604307
(87) Internationale Veröffentlichungsnummer: WO9713664

(56) Entgegenhaltungen:
- EP-A- 0 224 044
- EP-A- 0 418 989
- DE-A- 3 208 527
- DE-A- 4 324 590

## Beschreibung

Die Erfindung betrifft ein optisches Erfassungssystem in einer Waschanlage für Fahrzeuge sowie ein Verfahren zu deren Betrieb.

Ein solches optisches Erfassungssystem nebst Betriebsverfahren ist aus der DE-A-43 24 590 bekannt. Das einer Trockeneinrichtung zugeordnete optische Erfassungssystem besitzt eine Regelung, die die Ansprechempfindlichkeit bzw. das Durchdringungsvermögen während der Fahrzeugbehandlung permanent überwacht und regelt. Hierdurch soll das System lichtdurchlässige Glasscheiben sicher von der lichtundurchlässigen Karosserie unterscheiden können. Außerdem soll eine Anpassung an sich verändernde Umgebungseinflüsse stattfinden können. Im Betrieb wird der Empfangspegel unter Berücksichtigung des Sendestroms mit vorgebebenen Schwellwerten verglichen. Verändert sich der Empfangspegel gegenüber dem Sendestrom, wird der Sendestrom entsprechend nachgeregelt. Diese Regelvorgänge finden während eines bestimmten Behandlungsprozesses statt, insbesondere der Trocknung, und treten dabei auch mit einer gewissen zeitlichen Verzögerung ein. Die Schwellwerte bleiben jedoch konstant. Ein rechtzeitiges und vor allem sicheres Anpassen an die bei den unterschiedlichen Behandlungsprozessen in einem Waschvorgang herrschenden variierenden Betriebsbedingungen ist dabei nicht möglich.

Aus der DE-A-35 40 767 ist es bekannt, bei einem optischen Erfassungssystem in Form einer Lichtschranke in einer Autowaschanlage vor dem Trocknungsvorgang einen Abgleich der Lichtschranke durchzuführen und dabei das Durchdringungsvermögen der Lichtschranke auf einen zum Feststellen der Strahlfreigabe gerade ausreichenden Wert einzustellen. Beim Abgleich werden Verschmutzungen, Trübungen und sonstige Dämpfungen der Strahlintensität festgestellt und automatisch kompensiert. Dabei wird bei gegebenem Strahl die Empfindlichkeit bzw. Ansprechschwelle des Empfängers durch Veränderung des Verstärkungsfaktors solange verstellt, bis das Schrankensignal von Strahlfreigabe auf Strahlunterbrechung wechselt. Von diesem Schaltwert aus wird die Schaltschwelle entsprechend der gewünschten Empfindlichkeit zurückgestellt. Diese Anordnung ist nur für das Trockenaggregat vorgesehen und sieht eine feste Einstellung für das Durchdringungsvermögen vor.

Aus der DE-A-39 31 038 bzw. der EP-A-0 418 989 ist es bekannt, das Durchdringungsvermögen einer Lichtschranke permanent zu regeln, indem Verschmutzungen, Trübungen etc. festgestellt und durch eine Anhebung der Senderleistung kompensiert werden. Auch hier ist die Lichtschranke mit ihrem Durchdringungsvermögen auf einen festen Wert eingestellt, der sich anhand eines Potentiometers verändern und auf den jeweiligen Einsatzzweck manuell einstellen läßt.

Die Erfindung hat zur Aufgabe, ein verbessertes optisches Erfassungssystem nebst Betriebsverfahren mit höherer Nutzbarkeit aufzuzeigen.

Die Erfindung löst diese Aufgabe mit den Merkmalen im Anspruch 1 bzw 8.

Das erfindungsgemäße optische Erfassungssystem läßt sich automatisch und von der Waschanlage her prozeßgesteuert auf unterschiedliche Vorgabewerte für das Durchdringungsvermögen einstellen. Dies ermöglicht den Einsatz des optischen Erfassungssystems in verschiedenen Behandlungsprozessen, wobei den jeweiligen betriebsbedingten Anforderungen an das optische Erfassungssystem automatisch Rechnung getragen werden kann. Dadurch können mehrere Behandlungsaggregate zusammengefaßt und mit einem gemeinsamen optischen Erfassungssystem ausgerüstet werden.

Bei den Verschiedenen Vorgabewerten kann außerdem eine Kalibrierung des optischen Erfassungssystems stattfinden. Im Betrieb empfiehlt es sich, zu Beginn des Waschprozesses oder auch jedesmal vor Beginn der einzelnen Behandlungsgänge einen Abgleich des optischen Erfassungssystems durchzuführen. Hierdurch werden Beeinträchtigungen des maximalen Durchdringungsvermögens durch Verschmutzung, Trübungen oder andere Beeinflussungen von Sender und/oder Empfänger festgestellt und automatisch kompensiert. Die für die Umschaltung vorgesehenen Durchdringungswerte beziehen sich auf das durch den Abgleich festgestellte maximal noch vorhandene Durchdringungsvermögen. Über den Abgleich kann auch festgestellt werden, ob der vorhandene Einstellbereich noch ausreichend groß ist und gegebenenfalls ein Warnsignal abgesetzt werden.

Das optische Erfassungssystem besteht aus einem mit Sender und Empfänger ausgerüsteten Strahlsystem, bei dem es sich bespielsweise um eine Einweg- oder Reflexionslichtschranke, einem Reflexionslichttaster oder dergleichen handeln kann. Die Lichtschranken oder Taster können im sichtbaren Lichtbereich, aber auch im unsichtbaren Infrarot- oder Ultraviolettbereich arbeiten.

Ferner besitzt das optische Erfassungssystem eine vorzugsweise in einen Verstärker integrierte Auswerteschaltung, die an die Maschinensteuerung außer den Schaltsignalen der Strahlschranke auch ein die Strahlintensität bzw. das Durchdringungsvermögen repräsentierendes Analogsignal abgibt. Über dieses Analogsignal läßt sich der Verschmutzungsgrad kontrollieren und gegebenenfalls eine Warnschwelle feststellen. Das Analogsignal kann aber auch bei der Montage zum Ausrichten von Sender und Empfänger eingesetzt werden.

In den Unteransprüchen sind weitere vorteilhafte Ausgestaltungen der Erfindung angegeben.

Die Erfindung ist in den Zeichnungen schematisch und beispielsweise dargestellt. Im einzelnen zeigen:
- Figur 1:: eine Fahrzeugwaschanlage mit einem optischen Erfassungssystem und
- Figur 2:: eine Schemadarstellung des optischen Erfassungssystems.

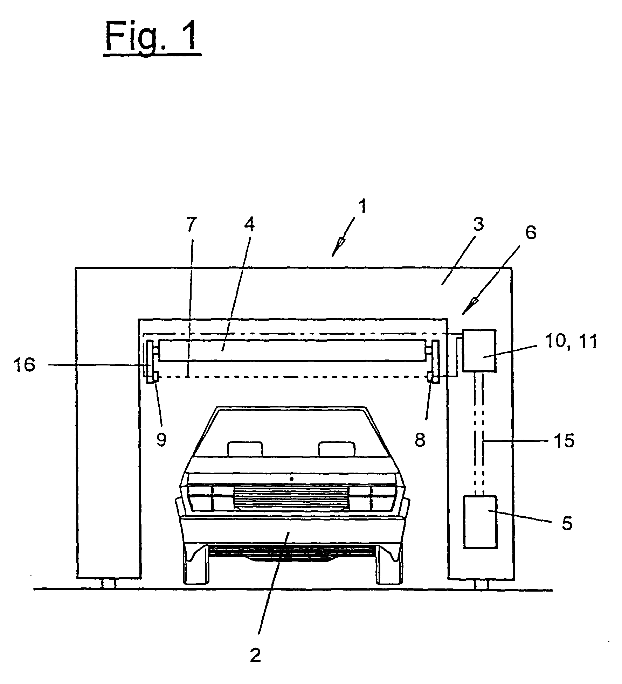

Figur 1 zeigt eine Waschanlage (1) für Fahrzeuge (2), die als Portalwaschanlage, Autowaschstraße, Doppelportalanlage oder in dergleichen anderen beliebigen Ausführungsformen gestaltet sein kann. Die Waschanlage (1) besitzt ein oder mehrere Portale (3) oder sonstige geeignete Ständer oder Halter für ein oder mehrere Behandlungsaggregate (4), die relativ zum Fahrzeug (2) bewegt werden. Die Bewegungen können horizontal, vertikal oder schräg erfolgen. Bei den Behandlungsaggregaten (4) kann es sich um Hochdruckdüsen, Waschbürsten, Trockendüsen, Sprüheinrichtungen oder dergleichen handeln. Die Behandlungsaggregate (4) können sowohl im Dachbereich als auch an den Seitenflächen des Fahrzeugs (2) angeordnet sein.

In der bevorzugten Ausführungsform sind zwei oder mehr Behandlungsaggregate (4) zu einer Einheit zusammengefaßt. Hierbei können z.B. ein Sprührohr für Chemikalien, Spülwasser oder dergleichen, ein Hochdruckdüsenrohr und eine Trockendüse miteinander an einem gemeinsamen Träger (16) gelagert sein. Figur 1 zeigt schematisch eine solche Vereinigung von Dachaggregaten, die der Höhenkontur des Fahrzeugs (2) folgend über Motorhaube, Frontscheibe, Dach, Heckscheibe und Fahrzeugheck bewegt werden.

Um einen möglichst gleichbleibenden Abstand und gegebenenfalls eine prozeßbedingte Orientierung der Behandlungsaggregate (4) relativ zur Fahrzeugoberfläche einzuhalten und um auch Kollisionen vorzubeugen, sind die Behandlungsaggregate (4) mit einem optischen Erfassungssystem (6) ausgerüstet. Wenn mehrere Behandlungsaggregate (4) zu einer Einheit zusammengefaßt sind, haben sie vorzugsweise ein gemeinsames optisches Erfassungssystem (6).

Das optische Erfassungssystem (6) ist unterhalb und bezüglich der Bewegungsrichtung zwischen Portal (3) und Fahrzeug (2) mit einem gewissen Vorlauf gegenüber den Behandlungsaggregaten (4) angeordnet. Es tastet mittels eines Strahls (7), vorzugsweise eines horizontalen, vertikalen oder schrägen Lichtstrahls, die Höhen- oder Seitenkontur des Fahrzeugs ab und gibt entsprechende Signale an die Maschinensteuerung (5), die das im Betrieb befindliche Behandlungsaggregat (4) entsprechend an das Fahrzeug (2) zustellt.

Das optische Erfassungssystem arbeitet mit ein oder mehreren Strahlen (7), vorzugsweise Lichtstrahlen. Die Lichtfrequenzen können im sichtbaren oder unsichtbaren Bereich liegen. Es kann sich auch um andere Arten von Strahlen handeln.

Das optische Erfassungssystem besitzt ein oder mehrere Sender (8) und eine entsprechende Anzahl von Empfängern (9). Im gezeigten Ausführungsbeispiel von Figur 1 handelt es sich um Einweglichtschranken, bei denen Sender (8) und Empfänger (9) einander gegenüberliegend beidseits des Fahrzeugs (2) angeordnet sind. Alternativ können auch Reflexionslichtschranken zum Einsatz kommen, bei denen Sender und Empfänger auf einer Fahrzeugseite nebeneinander angeordnet sind und mit einem Reflektor auf der gegenüberliegenden Fahrzeugseite zusammenwirken. Ferner ist der Einsatz von Reflexionslichttastern möglich, bei denen das Fahrzeug (2) selbst den Reflektor darstellt. Darüber hinaus sind weitere Abwandlungen der Gerätekonfiguration und der Einsatzmodalitäten, z.B. die Verwendung von polarisiertem Licht etc. möglich.

Während der verschiedenen Behandlungsprozesse bei der Fahrzeugwäsche herrschen unterschiedliche Betriebsbedingungen für das optische Erfassungssystem (6). Beim Sprühvorgang oder der Hochdruckwäsche kann es einen Wassernebel geben, der den Strahl (7) schwächt. In diesem Fall empfiehlt sich für das optische Erfassungssystem (6) ein hohes Durchdringungsvermögen. Beim Trocknungsvorgang hingegen bestehen keine derartigen Beeinträchtigungen des Strahls (7). Statt dessen ist hier das Problem der Durchleuchtung von Glasflächen vorhanden, die den Strahl (7) nur geringfügig dämpfen und trotzdem sicher als Fläche erkannt werden sollen. In diesem Fall ist ein niedriges Durchdringungsvermögen des optischen Erfassungssystems (6) günstig.

Das optische Erfassungssystem (6) wird prozeßgesteuert auf die unterschiedlichen Betriebsbedingungen und auf unterschiedliche vorgegebene Werte für das Durchdringungsvermögen eingestellt. Die Einstellung wird vorzugsweise von der Maschinensteuerung (5) veranlaßt. Beim Trocknungsvorgang werden beispielsweise 25% des maximal möglichen Durchdringungsvermögens und beim Spül- oder Waschvorgang 100% eingestellt. Die genannten Vorgabewerte haben sich in der Praxis als sinnvoll erwiesen. Sie können aber auch variieren, z.B. 30% bei der Trocknung. Die Maschinensteuerung (5) ist flexibel und kann beliebige Vorgabewerte einstellen.

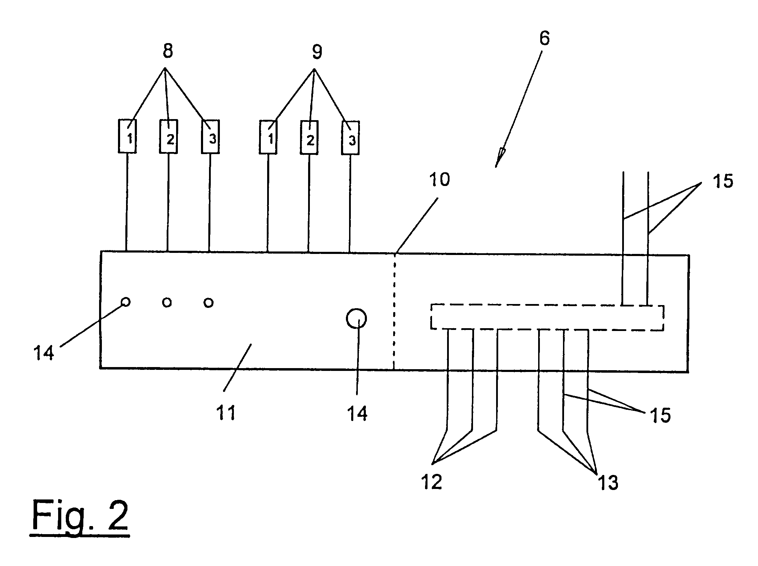

Wie Figur 2 näher verdeutlicht, besitzt das optische Erfassungssystem (6) eine mit Sender (8) und Empfänger (9) verbundene Auswerteschaltung (10), die vorzugsweise in einen Verstärker (11) integriert oder mit diesem kombiniert ist. Sie kann auch separat angeordnet sein. Die Einstellung der unterschiedlichen Werte für das Durchdringungsvermögen erfolgt vorzugsweise durch eine Veränderung der Vorgabe-Empfindlichkeit bzw. Ansprechschwelle der Empfänger (9). Alternativ kann auch die Sendeleistung der Sender (8) verändert werden. Für ein hohes Durchdringungsvermögen wird eine hohe Sendeleistung oder eine niedrige Empfindlichkeit des Empfängers (9) und für ein geringes Durchdringungsvermögen eine niedrige Sendeleistung oder eine hohe Empfindlichkeit des Empfängers (9) eingestellt. Die Einstellung erfolgt über den Verstärker (11).

Die Auswerteschaltung (10) steht mit der Maschinensteuerung (5) über entsprechende Leitungen (15) in einer bidirektionalen Signal- oder Steuerverbindung. Die Auswerteschaltung (10) hat für jedes der gegebenenfalls mehrfach vorhandenen Sender-/Empfängerpaare einen digitalen Schaltausgang (12), über den der Schaltzustand der Lichtschranke als Ein-/Aussignal an die Maschinensteuerung (5) gemeldet wird. Daneben ist für jede Sender-/Empfängerpaarung zusätzlich ein analoger Ausgang (13) vorhanden, über den ein Meßsignal an die Maschinensteuerung (5) abgegeben wird, das die Strahlintensität bzw. das vorhandene tatsächliche Durchdringungsvermögen angibt.

Vor Beginn der Fahrzeugwäsche oder vor ein oder mehreren einzelnen Behandlungsprozessen kann ein Abgleich des optischen Erfassungssystems (6) erfolgen. Hierfür ist in der Auswerteschaltung (10) eine entsprechende Funktion implementiert, die auf ein Signal von der Maschinensteuerung (5) aktiviert wird. Beim Abgleich wird der Sender (8) jeder Lichtschranke auf maximale Sendeleistung eingestellt und am zugehörigen Empfänger (9) die Intensität des ankommenden Strahls (7) gemessen und als Analogsignal ausgegeben.

Eventuelle Verschmutzungen, Trübungen, Beschädigungen oder dergleichen andere Einflüsse können die Intensität des Strahls (7) dämpfen. Dieser Dämpfungsgrad wird beim Abgleich ermittelt und für die Einstellung des Durchdringungsvermögens der einzelnen Lichtschranken herangezogen. Die für die einzelnen Behandlungsprozesse erforderlichen hohen oder niedrigen Werte für die Durchdringung beziehen sich auf das maximale vorhandene Durchdringungsvermögen.

Wenn z.B. der Empfänger bei sauberer Lichtschranke und 100% Lichtintensität 10 Volt als Meßsignal abgibt, wird die Schaltschwelle für eine hohe Empfindlichkeit von z.B. 8,5 bis 9 Volt und für eine niedrige Empfindlichkeit z.B. auf einen Bereich von 7 bis 9 Volt eingestellt. Liegt eine Verschmutzung vor, die das Empfängersignal auf z.B. 9 Volt senkt, werden die Empfindlichkeitswerte entsprechend niedriger eingestellt, z.B. auf 7,5 bis 8 Volt für gesteigerte Empfindlichkeit und 6 bis 8 Volt für abgeschwächte Empfindlichkeit. Liegt im Betrieb der Meßwert innerhalb der eingestellten Empfindlichkeitsbereiche, wird an die Maschinensteuerung (5) Strahlfreigabe gemeldet. Ein Meßwert außerhalb dieser Empfindlichkeitswerte wird als Strahlunterbrechung gemeldet.

Alternativ kann die Kalibrierung auch durch eine Veränderung der Sendeleistung des Senders (8) erzielt werden. Hierzu wird für die Grundeinstellung bei einer Teil-Sendeleistung von z.B. 75% und sauberer Optik (6) sowie freiem Strahl (7) die Spannung am Empfänger (9) gemessen, z.B. 9 V, und als Schaltwert für die 100%-Durchdringung definiert. Hiervon ausgehend werden die Sendeleistung und der Schaltwert für die 25%-Durchdringung festgelegt, z.B. 7 V. Im Betrieb wird zur Kalibrierung die Sendeleistung auf die Vorgabewerte entsprechend der gewünschten Durchdringung bzw. Intensität eingestellt und die dabei anliegende Empfängerspannung gemessen. Wird durch Verschmutzungen etc. die zugehörige Empfängerspannung innerhalb eines gewissen Toleranzbereichs nicht erreicht, wird die Sendeleistung erhöht und nachgeregelt.

Die beim Abgleich gemessenen Spannungen am Empfänger (9) werden über die analogen Ausgänge (13) abgegeben. Sie können auch zur Justierung des optischen Erfassungssystems (6) herangezogen werden. Hierdurch kann z.B. bei der Montage eine optimale Ausrichtung von Sender (8) und Empfänger (9) eingestellt werden, die dann gegeben ist, wenn am Empfänger (9) das Signal maximal ist.

### BEZUGSZEICHENLISTE

- 1: WASCHANLAGE
- 2: FAHRZEUG
- 3: PORTAL
- 4: BEHANDLUNGSAGGREGAT
- 5: MASCHINENSTEUERUNG
- 6: OPTISCHES ERFASSUNGSSYSTEM, LICHTSCHRANKE
- 7: STRAHL
- 8: SENDER
- 9: EMPFÄNGER
- 10: AUSWERTESCHALTUNG
- 11: VERSTÄRKER
- 12: AUSGANG, DIDITAL
- 13: AUSGANG, ANALOG
- 14: ANZEIGE
- 15: LEITUNG
- 16: TRÄGER

## Patentansprüche

1. Verfahren zum Betrieb eines optischen Erfassungssystems (6) in einer Waschanlage (1) für Fahrzeuge (2), wobei das Durchdringungsvermögen des optischen Erfassungssystems (6) verändert wird, dadurch **gekennzeichnet,** daß das Durchdringungsvermögen des in verschiedenen Behandlungsprozessen eingesetzten optischen Erfassungssystems (6) in Abhängigkeit vom Behandlungsprozeß und den dabei herrschenden unterschiedlichen Betriebsbedingungen auf unterschiedliche Vorgabewerte umgeschaltet wird.

2. Verfahren nach Anspruch 1, dadurch **gekennzeichnet,** daß beim Waschprozeß das Durchdringungsvermögen des optischen Erfassungssystems (6) erhöht wird.

3. Verfahren nach Anspruch 1, dadurch **gekennzeichnet,** daß beim Trockenprozeß das Durchdringungsvermögen des optischen Erfassungssystems (6) verringert wird.

4. Verfahren nach Anspruch 1, 2 oder 3, dadurch **gekennzeichnet,** daß bei der Erhöhung des Durchdringungsvermögens die Leistung des Senders (8) erhöht und/oder die Empfindlichkeit des Empfängers (9) verringert wird.

5. Verfahren nach Anspruch 1, 2 oder 3, dadurch **gekennzeichnet,** daß bei der Verringerung des Durchdringungsvermögens die Leistung des Senders (8) gesenkt und/oder die Empfindlichkeit des Empfängers (9) gesteigert wird.

6. Verfahren nach einem der Ansprüche 1 bis 5, dadurch **gekennzeichnet,** daß vor mindestens einem Behandlungsprozeß ein Abgleich des optischen Erfassungssystems (6) auf das tatsächliche maximal vorhandene Durchdringungsvermögen durchgeführt wird.

7. Verfahren nach Anspruch 6, dadurch **gekennzeichnet,** daß die Umschaltwerte auf das maximal vorhandene Durchdringungsvermögen bezogen sind.

8. Optisches Erfassungssystem (6) in einer Waschanlage (1) für Fahrzeuge (2), dessen Durchdringungsvermögen veränderbar ist, dadurch **gekennzeichnet,** daß das Durchdringungsvermögen des in verschiedenen Behandlungsprozessen eingesetzten optischen Erfassungssystems (6) in Abhängigkeit vom Behandlungsprozeß und den dabei herrschenden unterschiedlichen Betriebsbedingungen auf unterschiedliche Vorgabewerte umschaltbar ist.

9. Optisches Erfassungssystem nach Anspruch 8, dadurch **gekennzeichnet,** daß das optische Erfassungssystem (6) eine Auswerteschaltung (10) aufweist, die mit der Maschinensteuerung (5) verbunden ist.

10. Optisches Erfassungssystem nach Anspruch 9, dadurch **gekennzeichnet,** daß die Auswerteschaltung (10) in einen Verstärker (11) integriert ist.

11. Optisches Erfassungssystem nach Anspruch 8, 9 oder 10, dadurch **gekennzeichnet,** daß das optische Erfassungssystem (6) ein oder mehrere einen Strahl (7) emittierende Sender (8) und ein oder mehrere Empfänger (9) mit einstellbarer Sendeleistung und/oder Empfindlichkeit aufweist.

12. Optisches Erfassungssystem nach Anspruch 8 oder einem der folgenden, dadurch **gekennzeichnet,** daß das optische Erfassungssystem (6) ein analoges Signal für die Strahlintensität abgibt.

13. Optisches Erfassungssystem nach Anspruch 8 oder einem der folgenden, dadurch **gekennzeichnet,** daß die Auswerteschaltung (10) eine Abgleichfunktion für Sender (8) und Empfänger (9) beinhaltet.

## Claims

1. Method for operating an optical detection system (6) in a washing installation (1) for vehicles (2), the penetrative capability of the optical detection system (6) being varied, characterized in that the penetrative capability of the optical detection system (6) used in different treatment processes is changed over to different preset values, depending on the treatment process and the different operating conditions obtaining in it.

2. Method according to Claim 1, characterized in that the penetrative capability of the optical detection system (6) is increased during the washing process.

3. Method according to Claim 1, characterized in that the penetrative capability of the optical detection system (6) is reduced during the drying process.

4. Method according to Claim 1, 2 or 3, characterized in that, when the penetrative capability is increased, the power of the transmitter (8) is increased and/or the sensitivity of the receiver (9) is reduced.

5. Method according to Claim 1, 2 or 3, characterized in that, when the penetrative capability is reduced, the power of the transmitter (8) is lowered and/or the sensitivity of the receiver (9) is raised.

6. Method according to one of Claims 1 to 5, characterized in that, before at least one treatment process, the optical detection system (6) is tuned to the actual maximum penetrative capability present.

7. Method -according to Claim 6, characterized in that the changeover values refer to the maximum penetrative capability present.

8. Optical detection system (6) in a washing installation (1) for vehicles (2), the penetrative capability of said optical detection system (6) being variable, characterized in that the penetrative capability of the optical detection system (6) used in different treatment processes can be changed over to different preset values, depending on the treatment process and the different operating conditions obtaining in it.

9. Optical detection system according to Claim 8, characterized in that the optical detection system (6) has an evaluation circuit (10) which is connected to the machine controller (5).

10. Optical detection system according to Claim 9, characterized in that the evaluation circuit (10) is integrated in an amplifier (11).

11. Optical detection system according to Claim 8, 9 or 10, characterized in that the optical detection system (6) has one or more transmitters (8), which emit a beam (7), and one or more receivers (9) with an adjustable transmission power and/or sensitivity.

12. Optical detection system according to Claim 8 or one of the subsequent claims, characterized in that the optical detection system (6) outputs an analogue signal for the beam intensity.

13. Optical detection system according to Claim 8 or one of the subsequent claims, characterized in that the evaluation circuit (10) contains a tuning function for transmitter (8) and receiver (9).

## Revendications

1. Procédé pour faire fonctionner un système de détection optique dans une installation (1) de lavage de véhicule (2) automobile, dans lequel on fait varier le pouvoir de pénétration du système (6) de détection optique, caractérisé en ce que l'on commute à différentes valeurs de consignes le pouvoir de pénétration du système (6) de détection optique utilisé dans diverses opérations de traitement en fonction de l'opération de traitement et des conditions de fonctionnement différentes qui y règnent.

2. Procédé suivant la revendication 1, caractérisé en ce que l'on augmente le pouvoir de pénétration du système (6) de détection optique pendant l'opération de lavage.

3. Procédé suivant la revendication 1, caractérisé en ce que l'on diminue le pouvoir de pénétration du système (6) de détection optique pendant l'opération de séchage.

4. Procédé suivant la revendication 1, 2 ou 3, caractérisé en ce que l'on augmente la puissance de l'émetteur (8) et/ou l'on diminue la sensibilité du récepteur (9) pour l'augmentation du pouvoir de pénétration.

5. Procédé suivant la revendication 1, 2 ou 3, caractérisé en ce que l'on abaisse la puissance de l'émetteur (8) et/ou l'on augmente la sensibilité du récepteur (9) pour diminuer le pouvoir de pénétration.

6. Procédé suivant l'une des revendications 1 à 5, caractérisé en ce que l'on effectue avant au moins une opération de traitement un réglage du système (6) de détection optique au pouvoir de pénétration réel que l'on a au maximum.

7. Procédé suivant la revendication 6, caractérisé en ce que les valeurs de commutation sont rapportées au pouvoir de pénétration que l'on a au maximum.

8. Système (6) de détection optique dans une installation (1) de lavage de véhicule (2) automobile dont on peut faire varier le pouvoir de pénétration, caractérisé en ce que le pouvoir de pénétration du système (6) de détection optique utilisé dans diverses opérations de traitement peut être commuté à différentes valeurs prescrites en fonction de l'opération de traitement et des différences de conditions de fonctionnement qui y règnent.

9. Système de détection optique suivant la revendication 8, caractérisé en ce que le système (6) de détection optique comporte un circuit (10) d'exploitation qui est relié à la commande (5) de la machine.

10. Système de détection optique suivant la revendication 9, caractérisé en ce que le circuit (10) d'exploitation est intégré à un amplificateur (11).

11. Système de détection optique suivant la revendication 8, 9 ou 10, caractérisé en ce que le système (6) de détection optique comprend un ou plusieurs émetteurs (8) émettant un faisceau (7) et un ou plusieurs récepteurs (9) à puissance d'émission et/ou sensibilité réglable.

12. Système de détection optique suivant la revendication 8 ou l'une des suivantes, caractérisé en ce que le système (6) de détection optique fournit un signal analogique pour l'intensité du faisceau.

13. Système de détection optique suivant la revendication 8 ou l'une des suivantes, caractérisé en ce que le circuit (10) d'exploitation contient une fonction de réglage pour l'émetteur (8) et le récepteur (9).
